# FASCICULE DE BREVET EUROPEEN

(11) **EP 3 092 879 B1**
(45) Date de publication et mention de la délivrance du brevet: **03.03.2021**
(21) Numéro de dépôt: 15705209.3
(22) Date de dépôt: 07.01.2015
(51) Int. Cl.: H05K 7/20, H01L 23/00, H01L 23/44

(54) **DISPOSITIF ÉLECTRONIQUE DE PUISSANCE À REFROIDISSEMENT AMÉLIORÉ**
ELEKTRONISCHE STROMVORRICHTUNG MIT VERBESSERTER KÜHLUNG
ELECTRONIC POWER DEVICE WITH IMPROVED COOLING

(30) Priorité: 07.01.2014 FR 1450097
(43) Date de publication de la demande: 16.11.2016
(73) Titulaire: SAFRAN ELECTRONICS & DEFENSE, 75015 Paris (FR)
(72) Inventeur: RIOU, Jean-Christophe, 75015 Paris (FR)
(74) Mandataire: Lavialle, Bruno François Stéphane
(86) Numéro de dépôt international: PCT/EP2015/050157
(87) Numéro de publication internationale: WO 2015/104285

(56) Documents cités:
- EP-A1- 0 534 440

## Description

La présente invention concerne un dispositif électronique et plus particulièrement un dispositif électronique soumis à des courants de puissance.

Un tel dispositif comprend généralement des composants électroniques de puissance qui sont fixés sur un support en céramique et reliées par des câbles à des conducteurs permettant la liaison électrique du dispositif électronique aux éléments auxquels il est destiné à être raccordé.

Il est connu d'utiliser ce type de dispositif par exemple pour l'alimentation des phases d'un moteur électrique. Dans cette application, les composants sont des commutateurs reliés par des diodes aux phases du moteur.

Le substrat en céramique est fixé sur une plaque de dissipation thermique, ou plan de pose, pour assurer le refroidissement des composants.

Cependant, les calories émises par les composants sont transmises à la plaque de dissipation thermique par le substrat céramique uniquement dans la zone de celui-ci s'étendant à l'aplomb de chaque composant. Le transfert thermique est de la sorte relativement limité de sorte que la température du dispositif en fonctionnement est assez élevée et oblige à écarter les composants les uns des autres pour favoriser leur refroidissement.

Il en résulte un encombrement relativement important du dispositif.

Il en résulte également une limitation de la puissance transmissible par les composants de manière à limiter leur échauffement.

Il est également connu du document EP 0 534 440 un circuit électronique disposé dans une enveloppe souple qui contient un liquide de refroidissement et qui est en contact avec un dissipateur thermique.

Un but de l'invention est de fournir un moyen permettant de mieux refroidir de tels dispositifs électroniques de manière à notamment permettre une augmentation de la densité de puissance de tels modules.

A cet effet, on prévoit, selon l'invention, un dispositif électronique comportant au moins un composant électronique monté sur un support et entouré d'une enveloppe déformable contenant un liquide thermiquement conducteur et électriquement isolant. Le dispositif comporte une plaque de dissipation thermique qui est sensiblement parallèle au support et espacée de celui-ci, et des moyens d'échange thermique par conduction entre l'enveloppe et la plaque. Le liquide thermiquement conducteur et électriquement isolant est choisi et l'enveloppe est agencée pour qu'une dilatation thermique de l'huile entraîne un effort d'application de l'enveloppe contre les moyens d'échange thermique par conduction.

L'évacuation vers la plaque de dissipation thermique des calories produites lors du fonctionnement du composant est assurée principalement par le liquide thermiquement conducteur et électriquement isolant (comme une huile silicone), l'enveloppe et les moyens d'échange thermique par conduction. Comme le liquide est au contact direct du composant, le transfert des calories vers le liquide puis l'enveloppe et les moyens d'échange thermique par conduction est favorisé, le liquide thermiquement conducteur présentant une plus grande surface d'échange entre le composant et la zone froide. Il en résulte que le refroidissement du composant est relativement efficace. En outre, l'échauffement du liquide va provoquer une dilatation de celui-ci de sorte que le liquide va exercer une pression sur l'enveloppe, pression qui va renforcer le contact de l'enveloppe avec les moyens d'échange thermique par conduction, améliorant ainsi encore l'efficacité du transfert thermique.

De préférence, les moyens d'échange thermique comprennent des plots thermiquement conducteurs qui s'étendent sur la plaque de dissipation thermique et qui ont des extrémités libres espacées les unes des autres pour prendre contact avec l'enveloppe.

La déformabilité de l'enveloppe lui permet d'épouser au moins en partie la forme des extrémités libres des plots, augmentant la surface d'échange thermique avec ceux-ci.

Avantageusement, les plots sont agencés pour pouvoir être écrasés par l'enveloppe du fait d'une dilatation thermique du liquide thermiquement conducteur et électriquement isolant.

Cet écrasement va augmenter la surface d'échange entre l'extrémité libre des plots et l'enveloppe.

Ces plots peuvent être en matériaux non déformables ou déformables en argent, indium, voire en matériaux à mémoire de forme (alliage de fer et de titane par exemple). Un alliage à mémoire de forme est un alliage possédant plusieurs propriétés spécifiques :
- la capacité de revenir à une forme initiale après une déformation suite à l'application d'un simple chauffage,
- la possibilité d'alterner entre deux formes préalablement « mémorisées » lorsque sa température varie autour d'une température critique. Le matériau prendra l'une des formes en dessous de la température critique et une autre forme au-dessus,
- un comportement super-élastique permettant des allongements sans plastification supérieurs (10%) à ceux des autres métaux (quelques pourcents),
- l'effet « caoutchoutique » (l'alliage sous forme martensitique auto-accommodée subissant une déformation conserve au relâchement une déformation résiduelle ; si le matériau est à nouveau contraint puis déchargé, cette déformation résiduelle augmente),
- l'effet amortissant car l'alliage est capable d'amortir des chocs ou d'atténuer des vibrations mécaniques (la super-élasticité ou même simplement l'élasticité de la phase martensitique présentent un phénomène d'Hystérésis qui entraîne une dissipation de l'énergie).

Le matériau à mémoire de forme utilisé pourra être ainsi déformé lors de l'intégration du module et sera choisi pour avoir une température critique pour retour en position initiale qui soit cohérente avec les températures de fonctionnement du module. Ainsi, le matériau reste toujours dans la même position, en appui constant et élastique entre l'enveloppe et le plan de pose pendant le fonctionnement. Lors d'un démarrage à froid, le matériau à mémoire de forme se déformera vers l'autre position se déconnectant ainsi de l'enveloppe et isolant thermiquement de fait le module du plan de pose. Ainsi, cette procédure permettra d'accélérer grandement le temps de démarrage à froid du module de puissance, celui-ci se réchauffant ainsi que l'atmosphère et permettant une mise en contact des plots en matière à mémoire de forme.

Selon un mode de réalisation particulier, le support comprend un conducteur électrique de type busbar, le dispositif comportant un moyen de compensation des dilatations différentielles entre le conducteur et le composant et, de préférence, le moyen de compensation comprend un tronçon du conducteur qui s'étend au voisinage du composant et est amincie en épaisseur.

Le support assure alors également une fonction de liaison électrique tout en absorbant les dilatations différentielles. Ceci permet en outre de simplifier la structure du dispositif car les connexions et les composants sont sur un même substrat (à savoir le busbar). Les clips de connexion peuvent être en cuivre, potentiellement adouci, ou en matériau à mémoire de forme. Dans ce dernier cas, on choisira le matériau pour mettre en œuvre soit la caractéristique de super-élasticité soit la caractéristique d'effet « caoutchoutique »), ces caractéristiques lui permettant d'encaisser de fait de très grandes dilatations thermiques, comparativement aux matériaux classiques (cuivre non adouci, fer, nickel...) avec un vieillissement amélioré en cyclage thermique passif ou en cyclage de puissance.

D'autres caractéristiques et avantages de l'invention ressortiront à la lecture de la description qui suit de modes de réalisation particuliers non limitatifs de l'invention.

Il sera fait référence aux dessins annexés, parmi lesquels :
- la figure 1 est une vue schématique en coupe transversale d'un dispositif selon l'invention,
- la figure 2 est une vue schématique, en coupe transversale selon la ligne II-II de la figure 1, d'un des composants de ce dispositif selon une variante de réalisation avantageuse de l'invention,
- la figure 3 est une vue de détail en coupe selon le plan III de la figure 1 d'un moyen de compensation des dilatations différentielles.

Le dispositif électronique est ici décrit en application à l'alimentation d'un moteur électrique.

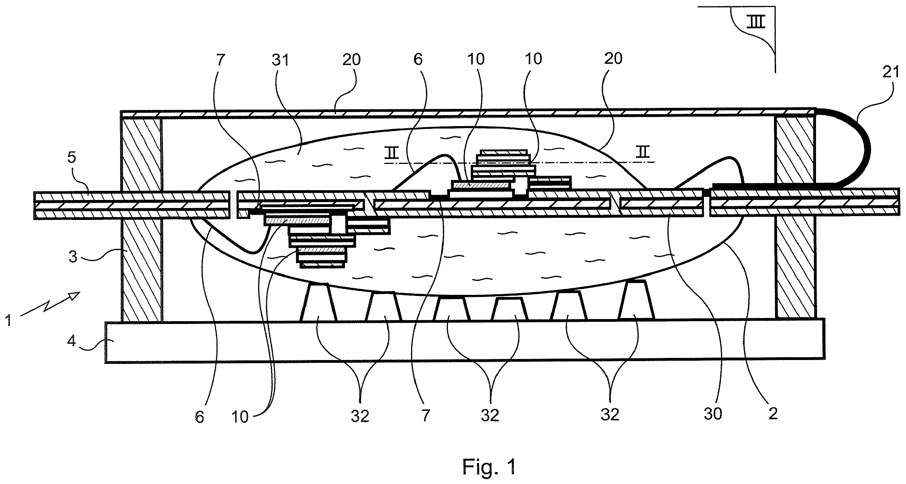

En référence à la figure 1, le dispositif électronique comporte un support, généralement désigné en 1, pour des composants électroniques de puissance à savoir des commutateurs 10, et une carte de commande 20.

Le support 1 comprend un conducteur électrique rigide sous forme de busbar 2 traversant un cadre 3 ayant un bord solidaire d'une plaque de dissipation thermique 4 ou plan de pose et un bord opposé sur lequel est fixée la carte de commande 20.

La carte de commande 20 est de type à composants montés en surface (CMS ou « Chip on board ») et est reliée au busbar 2 par des conducteurs flexibles 21.

Le busbar 2 a une extrémité 5 en saillie latérale du cadre 3 formant des moyens d'entrée / sortie de puissance. Le busbar 2 comprend ici au moins deux couches de pistes conductrices séparées par une couche d'isolant.

Les commutateurs 10 sont ici des commutateurs à jonctions de type transistor IGBT, MOSFET, SIC MOSFET, JFET, GaN. Les commutateurs 10 au nombre de quatre et sont montés par paire l'un sur l'autre respectivement sur une des deux faces du busbar 2. Chaque commutateur 10 est électriquement relié au busbar 2 soit par soudure de portions du commutateur 10 directement sur le busbar 2 soit par des fils conducteurs 6 aux extrémités soudées respectivement sur le busbar 2 et sur le commutateur 10. Les commutateurs 10 sont reliés les uns aux autres en parallèle ou low side/high side pour former des branches d'un pont de pilotage du moteur. Les commutateurs 10 de chaque paire sont pilotés pour être conducteurs en alternance. De manière connue en elle-même, il est nécessaire de relier à chaque commutateur une diode de roue libre pour évacuer le courant de retour provenant de la charge lorsque le commutateur 10 est ouvert.

Le busbar 2 comprend des tronçons 7 qui s'étendent au voisinage des paires de commutateurs 10 et sont amincis en épaisseur. Les tronçons 7 forment des zones de relative souplesse formant des moyens de compensation des dilatations différentielles entre le busbar 2 et les commutateurs 10 de manière à réduire la contrainte dans les assemblages.

Chaque paire de commutateurs 10 est entouré d'une enveloppe déformable 30 contenant un liquide thermiquement conducteur et électriquement isolant 31. L'enveloppe déformable est en un métal et notamment un alliage de nickel tel que ceux produits sous la marque « Inconel » par la société Spécial Metals Corporation, et a ici une épaisseur comprise entre 10 µm et 100 µm. Le liquide thermiquement conducteur et électriquement isolant 31 est une huile silicone.

Le dispositif comporte des moyens d'échange thermique par conduction entre l'enveloppe 30 et la plaque de dissipation thermique 4. L'enveloppe 30 est agencée pour que, en dessous d'une température prédéterminée, l'enveloppe 30 soit décollée des moyens d'échange thermique par conduction.

Les moyens d'échange thermique par conduction comprennent des plots 32 thermiquement conducteurs qui s'étendent sur la plaque de dissipation thermique 4 et qui ont des extrémités libres espacées les unes des autres pour prendre contact avec l'enveloppe 30. Plus précisément ici, les plots 32 s'évasent en direction de la plaque de dissipation thermique 4 : ils ont ici une forme tronconique mais pourraient avoir une forme en tronc de pyramide.

Les plots 32 sont en argent et sont agencés pour pouvoir être écrasés par l'enveloppe 30 du fait d'une dilatation thermique du liquide thermiquement conducteur et électriquement isolant 31.

On comprend que lorsque la température des commutateurs augmente, le liquide 31 s'échauffe, se dilate et déforme la membrane 30 forçant celle-ci en appui des plots 32 pour assurer un transfert thermique par conduction vers la plaque de dissipation thermique 4. Si la température augmente encore, l'effort exercé par l'enveloppe 30 sur les plots 32 du fait de la dilatation du liquide 31 est suffisant pour déformer les plots 32.

Il en résulte une meilleure conduction du fait de la force de contact et de l'augmentation de la surface de contact.

On notera que l'agencement des moyens d'échange thermique permet de monter des composants de puissance sur les deux faces du busbar 2. Il est donc possible de monter deux fois plus de composants de puissance dans le module de l'invention.

En maintenant une température moyenne de fonctionnement relativement faible, les moyens d'échange thermique permettent également de monter les commutateurs 10 par paire l'un sur l'autre (empilage). Ce principe de montage associé au pilotage en alternance des commutateurs permet non seulement un gain de place, comme on l'a vu, mais également de réduire les amplitudes thermiques subies par chaque commutateur pendant les cycles actifs en puissance : en effet, chacun des commutateurs dans son état passant, et donc émetteur de chaleur, entretient la température moyenne de la paire de commutateurs pendant que l'autre commutateur est dans son état bloqué. La limitation des cycles thermiques est favorable à la durée de vie des commutateurs.

Bien entendu, l'invention n'est pas limitée aux modes de réalisation décrits mais englobe toute variante entrant dans le champ de l'invention telle que définie par les revendications.

En particulier, les composants peuvent avoir une autre structure de celle décrite.

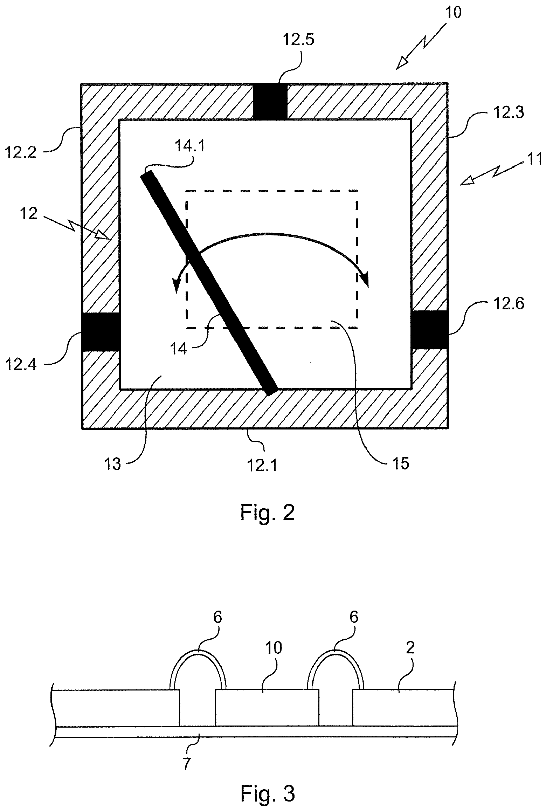

Dans une variante avantageuse de l'invention, et en référence à la figure 2, chaque commutateur 10 est un commutateur électronique de type MEMS comprenant un boîtier, généralement désigné en 11, ayant une paroi latérale 12 de contour fermé s'étendant entre deux plaques 13 pour délimiter une enceinte sous vide. La paroi latérale 12 est divisée en trois portions de connexion 12.1, 12.2, 12.3 qui sont électriquement conductrices et isolées l'une de l'autre par des portions électriquement isolantes 12.4, 12.5, 12.6. La portion de connexion 12.1 est reliée au moteur, la portion de connexion 12.2 est reliée à une source de potentiel positif et la portion de connexion 12.3 est reliée à une source de potentiel négatif. Un élément de contact 14, électriquement conducteur (avec par exemple un revêtement extérieur Nickel/Or), s'étend depuis la première portion de connexion 12.1 pour avoir son extrémité libre 14.1 mobile entre une première position dans laquelle l'extrémité libre 14.1 est en contact avec la deuxième portion de connexion 12.2 pour établir une liaison électrique entre ces deux portions de connexion et une deuxième position dans laquelle l'extrémité libre 14.1 est décollée de la deuxième portion de connexion 12.2. L'extrémité libre 14.1 est mobile entre la deuxième position et une troisième position dans laquelle l'extrémité libre 14.1 est en contact avec la troisième portion de connexion 12.3 pour établir une liaison électrique entre ces deux portions de connexion. La deuxième position s'étend donc entre la première position et la troisième position. L'élément de contact 14 est agencé pour être déplaçable entre ses deux positions sous l'effet d'un champ établi entre les deux plaques 13, c'est-à-dire un champ normal au plan de la figure 2. Chaque plaque 13 est pourvue d'une électrode 15 reliée à une source de potentiel via le circuit de commande de telle manière qu'un champ électrique puisse être établi entre les plaques 13. De tels commutateurs ont un temps de commutation très faible devant le temps de réaction du moteur. Ainsi, l'impulsion de retour envoyée par le moteur à la première portion de connexion 12.1 lors de la commutation n'a pas le temps de passer dans la portion de connexion 12.2, 12.3 en cours de déconnexion mais sera dirigée dans la portion de connexion 12.3, 12.2 en cours de connexion. Il n'est donc pas nécessaire de prévoir des diodes de roue libre pour bloquer cette impulsion de retour. L'enceinte sous vide permet d'éviter la formation d'un arc lors de la commutation.

Avantageusement encore, les commutateurs 10 de la figure 2 peuvent être agencés sous la forme d'un ensemble de commutateurs disposés en matrice et reliés à un circuit matriciel de commande dans lequel circulent des signaux de commande engendrant les champs dans les commutateurs. Ledit ensemble comprend alors de préférence une couche de polysilicium recouverte d'un isolant sur lequel les commutateurs sont disposés et des moyens de charge de la couche de polysilicium pour former une capacité. La capacité permet de maintenir le champ pendant une interruption involontaire du signal de commande.

Les plots peuvent comprendre l'un au moins des matériaux suivants : argent, indium, cuivre, nickel, fer, titane, aluminium. Les plots comme l'enveloppe sont réalisés dans des matériaux peu sensibles au fluage et à l'oxydation de telle manière que les performances de transfert thermique soient conservées pendant la durée de vie estimée du dispositif.

Le liquide thermiquement conducteur et électriquement isolant comprend au moins l'un des composants suivants : une huile silicone, un fluoropolyéther tel que celui commercialisé par la société Solvay sous les marques Galden et Fomblin.

Dans une version simplifiée, l'enveloppe du module peut aussi directement échanger avec un fluide caloporteur externe sans l'intermédiaire d'une interface thermique.

## Revendications

1. Dispositif électronique comportant au moins un composant électronique (10) monté sur un support (1) et entouré d'une enveloppe (30) déformable contenant un liquide (31) thermiquement conducteur et électriquement isolant, le dispositif comportant une plaque (4) de dissipation thermique qui est sensiblement parallèle au support et espacée de celui-ci, et des moyens d'échange thermique (32) par conduction entre l'enveloppe (30) et la plaque (4), le liquide thermiquement conducteur et électriquement isolant étant choisi et l'enveloppe étant agencée pour qu'une dilatation thermique du liquide entraîne un effort d'application de l'enveloppe contre les moyens d'échange thermique par conduction, **caractérisé en ce que** l'enveloppe est agencée pour que, en dessous d'une température prédéterminée, l'enveloppe soit décollée des moyens d'échange thermique par conduction.

2. Dispositif selon la revendication 1, dans lequel les moyens d'échange thermique comprennent des plots (32) thermiquement conducteurs qui s'étendent sur la plaque (4) de dissipation thermique et qui ont des extrémités libres espacées les unes des autres pour prendre contact avec l'enveloppe.

3. Dispositif selon la revendication 2, dans lequel les plots (32) sont agencés pour pouvoir être écrasés par l'enveloppe (4) du fait d'une dilatation thermique du liquide (3) thermiquement conducteur et électriquement isolant.

4. Dispositif selon la revendication 3, dans lequel les plots (32) peuvent comprendre l'un au moins des matériaux suivants : argent, indium, cuivre, nickel, fer, titane, aluminium.

5. Dispositif selon la revendication 2, dans lequel les plots (32) s'évasent en direction de la plaque (4) de dissipation thermique et/ou les plots (32) sont en matériau à mémoire de forme de manière à plaquer le plot (32) de manière élastique entre l'enveloppe (30) et la plaque (4) dans un domaine de températures de fonctionnement prédéterminé.

6. Dispositif selon la revendication 1, dans lequel le support comprend un conducteur électrique (2) de type busbar, le dispositif comportant un moyen de compensation (7) des dilatations différentielles entre le conducteur et le composant (10).

7. Dispositif selon la revendication précédente, dans lequel le moyen de compensation (7) comprend un tronçon du conducteur (2) qui s'étend au voisinage du composant (10) et est aminci en épaisseur.

8. Dispositif selon la revendication 1, dans lequel le liquide (31) thermiquement conducteur et électriquement isolant comprend au moins l'un des composants suivants : une huile silicone, un fluoropolyéther.

9. Dispositif selon la revendication 1, comprenant deux composants (10) électroniques de puissance destinés à être conducteurs en alternance, les deux composants (10) étant superposés d'un même côté du support (1).

10. Dispositif selon la revendication 1, comprenant au moins deux composants électroniques disposés chacun d'un côté du support.

11. Dispositif selon la revendication 1, dans lequel l'enveloppe (30) est en alliage de nickel tel que celui produit sous la marque « inconel ».

12. Dispositif selon la revendication 11, dans lequel l'enveloppe (30) a une épaisseur comprise entre 10 µm et 100 µm.

13. Dispositif selon la revendication 1, dans lequel le composant est un commutateur électronique (10) de type MEMS comprenant un boîtier (11) ayant une paroi latérale (12) de contour fermé s'étendant entre deux plaques (13) pour délimiter une enceinte sous vide, la paroi latérale comprenant une première portion (12.1) de connexion et au moins une deuxième portion (12.2) de connexion qui sont électriquement conductrices et isolées l'une de l'autre, un élément de contact (14) s'étendant depuis la première portion de connexion pour avoir son extrémité libre (14.1) mobile entre une première position dans laquelle l'extrémité libre est en contact avec la deuxième portion de connexion et une deuxième position dans laquelle l'extrémité libre est décollée de la deuxième portion de connexion, l'élément de contact étant agencé pour être déplaçable entre ses deux positions sous l'effet d'un champ établi entre les deux plaques.

14. Dispositif selon la revendication 13, dans lequel la paroi latérale (12) du commutateur comprend une troisième portion (12.3) de connexion et l'élément de contact (14) est agencé pour avoir son extrémité libre (14.1) mobile entre la première position de connexion et une troisième position dans laquelle l'extrémité libre est en contact avec la troisième portion de connexion, la deuxième position se trouvant entre les première et troisième position et l'extrémité libre en position de déconnexion étant décollée de la deuxième portion de connexion et de la troisième portion de connexion.

## Patentansprüche

1. Elektronische Vorrichtung, umfassend mindestens ein elektronisches Bauelement (10), das auf einem Träger (1) montiert und von einer verformbaren Hülle (30) umgeben ist, die eine wärmeleitende und elektrisch isolierende Flüssigkeit (31) enthält, wobei die Vorrichtung eine Wärmedissipationsplatte (4) umfasst, die im Wesentlichen parallel zu dem Träger und von demselben beabstandet ist, und Mittel (32) zum Wärmeaustausch durch Leitung zwischen der Hülle (30) und der Platte (4), wobei die wärmeleitende und elektrisch isolierende Flüssigkeit so gewählt und die Hülle so angeordnet ist, dass eine Wärmeausdehnung der Flüssigkeit eine Anpresskraft der Hülle gegen die Mittel zum Wärmeaustausch durch Leitung verursacht, **dadurch gekennzeichnet, dass** die Hülle so angeordnet ist, dass sie, unter einer vorbestimmten Temperatur, von den Mitteln zum Wärmeaustausch durch Leitung gelöst ist.

2. Vorrichtung nach Anspruch 1, bei der die Mittel zum Wärmeaustausch wärmeleitende Kontaktstücke (32) umfassen, die sich auf der Wärmedissipationsplatte erstrecken und freie Enden haben, die zueinander beabstandet sind, um mit der Hülle in Kontakt zu kommen.

3. Vorrichtung nach Anspruch 2, bei der die Kontaktstücke (32) so ausgebildet sind, dass sie von der Hülle (4) aufgrund einer Wärmeausdehnung der wärmeleitenden und elektrisch isolierenden Flüssigkeit zusammengedrückt werden können.

4. Vorrichtung nach Anspruch 3, bei der die Kontaktstücke (32) mindestens ein Material der folgenden Materialien umfassen können: Silber, Indium, Kupfer, Nickel, Eisen, Titan, Aluminium.

5. Vorrichtung nach Anspruch 2, bei der die Kontaktstücke (32) in Richtung der Wärmedissipationsplatte (4) weiter werden und/oder die Kontaktstücke (32) aus einem Formgedächtnismaterial sind, derart, dass das Kontaktstück (32) in einem vorbestimmten Betriebstemperaturbereich auf elastische Weise zwischen der Hülle (30) und der Platte (4) gepresst wird.

6. Vorrichtung nach Anspruch 1, bei der der Träger einen elektrischen Leiter (2) vom Typ Sammelschiene umfasst, wobei die Vorrichtung Ausgleichsmittel (7) zum Ausgleich unterschiedlicher Ausdehnungen zwischen dem Leiter und dem Bauelement (10) umfasst.

7. Vorrichtung nach dem vorhergehenden Anspruch, bei dem die Ausgleichsmittel (7) einen Abschnitt des Leiters (2) umfassen, der sich nahe dem Bauelement (10) erstreckt und in der Dicke verjüngt ist.

8. Vorrichtung nach Anspruch 1, bei dem die wärmeleitende und elektrisch isolierende Flüssigkeit (31) mindestens eine Komponente der folgenden Komponenten umfasst: ein Silikonöl, ein Fluorpolyether.

9. Vorrichtung nach Anspruch 1, umfassend zwei elektronische Leistungsbauelemente (10), die dazu bestimmt sind, abwechselnd leitend zu sein, wobei die beiden Bauelemente (10) auf einer selben Seite des Trägers (1) übereinander angeordnet sind.

10. Vorrichtung nach Anspruch 1, umfassend mindestens zwei elektronische Bauelemente, die jeweils auf einer Seite des Trägers angeordnet sind.

11. Vorrichtung nach Anspruch 1, bei der die Hülle (30) aus einer Nickellegierung besteht, wie z. B. derjenigen, die unter der Marke "Inconel" hergestellt wird.

12. Vorrichtung nach Anspruch 11, bei der die Hülle (30) eine Dicke zwischen 10 µm und 100 µm hat.

13. Vorrichtung nach Anspruch 1, bei der das Bauelement ein elektronischer Schalter (10) vom Typ MEMS ist, der ein Gehäuse (11) umfasst, das eine Seitenwand (12) mit geschlossener Kontur hat, die sich zwischen zwei Platten (13) erstreckt, um eine Vakuumkammer zu begrenzen, wobei die Seitenwand einen ersten Verbindungsabschnitt (12.1) und mindestens einen zweiten Verbindungsabschnitt (12.2) umfasst, die elektrisch leitend und zueinander isoliert sind, wobei sich ein Kontaktelement (14) von dem ersten Verbindungsabschnitt erstreckt, damit sein freies Ende (14.1) beweglich zwischen einer ersten Position, in der das freie Ende in Kontakt mit dem zweiten Verbindungsabschnitt ist, und einer zweiten Position ist, in der das freie Ende von dem zweiten Verbindungsabschnitt gelöst ist, wobei das Kontaktelement so ausgebildet ist, dass es zwischen seinen beiden Positionen unter der Wirkung eines zwischen den beiden Platten erzeugten Feldes bewegbar ist.

14. Vorrichtung nach Anspruch 13, bei der die Seitenwand (12) des Schalters einen dritten Verbindungsabschnitt (12.3) umfasst und das Kontaktelement (14) so angeordnet ist, dass sein freies Ende (14.1) beweglich zwischen der ersten Verbindungsposition und einer dritten Position ist, in der das freie Ende in Kontakt mit dem dritten Verbindungsabschnitt ist, wobei sich die zweite Position zwischen der ersten und der dritten Position befindet und das freie Ende in der Löseposition von dem zweiten Verbindungsabschnitt und dem dritten Verbindungsabschnitt gelöst ist.

## Claims

1. An electronic device comprising at least one electronic (10) component mounted on a support (1) and surrounded by a deformable casing (30) containing a heat-conducting and electrically-insulating liquid (31), the device comprising a heat dissipation plate (4) that is substantially parallel to the support and spaced apart therefrom, and heat exchange means (32) for heat exchange by conduction between the casing (30) and the plate (4), the heat-conducting and electrically-insulating liquid being selected and the casing being arranged so that thermal expansion of the liquid leads to the casing applying force against the means for heat exchange by conduction, the casing being arranged so that, below a predetermined temperature, the casing is not in contact with the means for heat exchange by conduction.

2. A device according to claim 1, wherein the heat exchange means comprise heat conducting studs (32) that extend over the heat dissipation plate (4) and that have free ends for making contact with the casing, which ends are spaced apart from one another.

3. A device according to claim 2, wherein the studs (32) are arranged to have the casing (4) press thereagainst as a result of thermal expansion of the heat-conducting and electrically-insulating liquid (3).

4. A device according to claim 3, wherein the studs (32) may comprise at least one of the following materials: silver, indium, copper, nickel, iron, titanium, aluminum.

5. A device according to claim 2, wherein the studs (32) widen going towards the heat dissipation plate and/or the studs (32) are made of a shape-memory material in such a manner as to press the stud (32) elastically between the casing (30) and the plate (4) in a predetermined range of operating temperatures.

6. A device according to claim 1, wherein the support comprises an electrical conductor (2) of the busbar type, the device comprising means (7) for compensating differential expansion between the conductor and the component (10).

7. A device according to the preceding claim, wherein the compensation means (7) comprise a segment of the conductor (2) that extends in the vicinity of the component (10) and that is of reduced thickness.

8. A device according to claim 1, wherein the heat-conducting and electrically-insulating liquid (31) comprises at least one of the following components: a silicone oil, a fluoropolyether.

9. A device according to claim 1, comprising two power electronics components (10) designed to conduct in alternation, both components (10) being superposed on the same side of the support.

10. A device according to claim 1, comprising at least two electronic components each placed on one side of the support.

11. A device according to claim 1, wherein the casing (30) is made of nickel alloy such as that produced under the trademark "inconel".

12. A device according to claim 11, wherein the casing (30) has a thickness lying in the range 10 µm and 100 µm.

13. A device according to claim 1, wherein the component is an electronic switch (10) of the MEMS type having a housing (12) having a side wall of closed outline extending between two plates (13) in order to define an evacuated enclosure, the side wall comprising a first connection portion (12.1) and at least one second connection portion (12.2) that are electrically conductive and insulated from one another, a contact element (14) extending from the first connection portion so that its free end (14.1) is movable between a first position in which the free end is in contact with the second connection portion and a second position in which the free end is not in contact with the second connection portion, the contact element being arranged to be movable between its two positions under the effect of a field established between the two plates.

14. A device according to claim 13, wherein the side wall (12) of the switch comprises a third connection portion (12.3) and the contact element (14) is arranged to have its free end (14.1) movable between the first connection position and a third position in which the free end is in contact with the third connection portion, the second position being located between the first and third positions and the free end in the disconnection position being not in contact with the second connection portion and the third connection portion.
